# EUROPÄISCHE PATENTSCHRIFT

(11) **EP 0 519 431 B1**
(45) Veröffentlichungstag und Bekanntmachung des Hinweises auf die Patenterteilung: **16.04.1997**
(21) Anmeldenummer: 92110241.4
(22) Anmeldetag: 17.06.1992
(51) Int. Cl.: C11D 7/50, H05K 3/26, C23G 5/028

(54) **Azeotropartiges Gemisch aus Methanol und 1H-Perfluorhexan**
Azeotrope-like mixture of methanol and 1H-perfluorohexane
Composition analogue à celle d'azéotrope de méthanol et 1H-perfluorohexane

(30) Priorität: 21.06.1991 DE 4120506
(43) Veröffentlichungstag der Anmeldung: 23.12.1992
(73) Patentinhaber: SOLVAY (Société Anonyme), B-1050 Bruxelles (BE)
(72) Erfinder: Robeck, Horst, W-6238 Hofheim am Taunus (DE); Deger, Hans-Matthias, Dr., W-6238 Hofheim am Taunus (DE)
(74) Vertreter: Jacques, Philippe

(56) Entgegenhaltungen:
- EP-A- 350 316
- EP-A- 0 431 458
- EP-A- 0 445 438
- EP-A- 0 516 029
- DATABASE WPIL Derwent Publications Ltd., London, GB; AN 91-374103

## Beschreibung

Es ist Stand der Technik, zum Reinigen von gelöteten Leiterplatten und anderen elektronischen Bauteilen Gemische aus 1,1,2-Trichlor-1,2,2-trifluorethan (R 113) und Alkoholen wie Methanol, Ethanol oder 2-Propanol einzusetzen (GB-PS 1 026 003, GB-PS 1 399 867). Aus US-PS 3 960 746 ist eine azeotropartige Mischung aus R 113, Methanol und Nitromethan für denselben Zweck bekannt. Da jedoch die FCKW im Verdacht stehen, die Ozonschicht zu schädigen, ist es notwendig, auf diese Stoffklasse zu verzichten.

Für den Bereich der Elektronik-Industrie, insbesondere zum Reinigen von Leitplatten nach dem Lötvorgang, werden zur Zeit verschiedene Systeme auf wäßriger Basis und auf Basis nichthalogenierter organischer Lösemittel diskutiert. Bei wäßrigen Reinigungsmitteln ist es jedoch schwierig, die richtige Tensid/Komplexbildner-Kombination zu finden. Auch muß das System an die mechanische Behandlung wie Spülen, Bürsten, Dampfstrahl, Ultraschall angepaßt werden. Bei der SMT (Surface Mount Technology)-Technik scheiden wäßrige Reinigungssysteme häufig aus, da sich das Wasser nur schwer wieder entfernen läßt.

Bei Einsatz nichthalogenierter organischer Lösemittel, wie Benzin, Alkohole, Terpene oder Ester ist aufgrund der Brennbarkeit und der Explosivität dieser Substanzen eine explosionsgeschützte Ausführung der Anlage erforderlich, so daß aus ökonomischen Gründen eine Verwendung in Oberflächenbehandlungsanlagen nur in wenigen Fällen infrage kommt.

In den nicht vorveröffentlichten deutschen Patentanmeldungen 4 002 120.3 und 4 013 369.9 werden azeotropartige Lösemittelgemische aus 1,4-Dihydroperfluorbutan und Methanol bzw. aus 2,2,2-Trifluorethyl-1,1,2,2-tetrafluorethylether und Ethanol beschrieben, welche für die Reinigung von elektrischen und elektronischen Bauteilen geeignet sind.

EP-A-0 350 316 beschreibt ein Verfahren zur Reinigung und Trocknung von Bauteilen, insbesondere von elektronischen Bauteilen, unter Verwendung eines brennbaren, flüssigen, organischen Lösungsmittels, das gegebenfalls Wasserstoff enthaltende, fluorierte Kohlenwasserstoffe, z.B. 1-H-Perfluorhexan, enthält. Als bevorzugte organische Lösungsmittel werden aliphatische C₁-C₅-Alkohole genannt. Die in EP-A-0 350 316 aufgeführten Gemische enthalten perfluorierte Kohlenwasserstoffe und aliphatische C₂-, C₃-Alkohole.

Überraschenderweise wurde nun gefunden, daß 1 H-Perfluorhexan CF₃-(CF₂)₄-CF₂H mit Methanol ein azeotropartiges Lösungsmittelgemisch bildet, welches hervorragend zur Reinigung von elektronischen Bauteilen, insbesondere gelöteten Leiterplatten oder gedruckten Schaltungen, vor allem zur Entfernung von Lötflußmitteln geeignet ist.

Ein Gegenstand der Erfindung ist ein azeotropartiges Gemisch, das etwa 5-9 Gew.-% Methanol und etwa 91-95 Gew.-% 1H-Perfluorhexan enthält. Vorzugsweise enthält das Gemisch 6,5-8,0 Gew.-% Methanol, insbesondere 7,0-7,8 Gew.-% Methanol, wobei der Rest jeweils 1H-Perfluorhexan ist. Ein weiterer Gegenstand der Erfindung ist ein Verfahren zur Reinigung von elektronischen Bauteilen, insbesondere gelöteten Leiterplatten oder gedruckten Schaltungen, das dadurch gekennzeichnet ist, daß man die Bauteile mit einem azeotropartigen Gemisch wäscht, das etwa 5-9 Gew.-% Methanol und 91-95 Gew.-% 1H-Perfluorhexan enthält. Vorzugsweise verwendet man ein Gemisch, das 6,5-8,0 Gew.-% Methanol, insbesondere 7,0-7,8 Gew.-% Methanol enthält, wobei der Rest jeweils im wesentlichen 1H-Perfluorhexan ist.

Ein besonders bevorzugtes Lösungsmittelgemisch enthält 92,6 Gew.-% 1H-Perfluorhexan und 7,4 Gew.-% Methanol und hat einen Siedepunkt bei 1 bar von 53,5 °C.

Bei dem erfindungsgemäßen Gemisch aus Methanol und 1H-Perfluorhexan ist die Zusammensetzung des Dampfes identisch oder im wesentlichen identisch mit der Zusammensetzung der Flüssigkeit, d.h. beim Verdampfen ändert sich die Zusammensetzung des Gemisches nicht oder nicht wesentlich. Das erfindungsgemäße Lösemittelgemisch hat den weiteren Vorteil, daß es kein Chlor enthält, und damit keine Ozonschädigung bewirkt. Außerdem ist es nicht brennbar und kann in den üblichen Ultraschall-, Tauch- und Bürstenwaschanlagen eingesetzt werden.

### Beispiel 1

Ein glasfaserverstärktes Basismaterial für Leiterplatten auf Polyesterbasis wurde mit einem handelsüblichen Lötflußmittel (Zeva® C 20-200 der Firma Zevatron, Hauptbestandteil Kolophonium, daneben Aktivatoren) bestrichen und 18 Stunden bei 60 °C im Trockenschrank getrocknet. Anschließend wurde das Material mit einem Gemisch aus 1H-Perfluorhexan (92,6 Gew.-%) und Methanol (7,4 Gew.-%) unter Anwendung von Ultraschall gewaschen. Die Einwirkzeiten betrugen 30-60 Sekunden, das Flußmittel wurde vollständig entfernt.

### Beispiel 2

Man ging vor wie in Beispiel 1, nur daß man ein anderes Lötflußmittel benutzte (Zeva® C 30- 300 der Firma Zevatron), welches wiederum als Hauptbestandteil Kolophonium neben Aktivatoren enthielt. Nach einer Einwirkzeit von 30-60 Sekunden war das Flußmittel vollständig entfernt. Bei den herkömmlichen Gemischen aus 1,1,2-Trichlor-1,2,2-trifluorethan mit Methanol, Ethanol oder 2-Propanol betragen die Behandlungszeiten dagegen je nach Flußmittel zwischen 60 und 90 Sekunden. Außerdem lassen sich ionische Rückstände mit dem Azeotrop besser entfernen als mit den herkömmlichen Gemischen.

### Beispiel 3

Beispiel 3 wurde wie Beispiel 1 durchgeführt, nur daß als Lötflußmittel das Flußmittel GR8 der Fa. Ersa (Hauptbestandteil Kollophonium, daneben Aktivatoren) verwendet wurden. Nach einer Einwirkzeit von 30-60 Sekunden war das Flußmittel vollständig entfernt.

## Patentansprüche (Patentansprüche für folgende(n) Vertragsstaat(en): BE, DE, DK, FR, GB, IT, NL)

1. Azeotropartiges Gemisch, das etwa 5-9 Gew.-% Methanol und etwa 91-95 Gew.-% 1 H-Perfluorhexan enthält.

2. Azeotropartiges Gemisch nach Anspruch 1, das etwa 6,5-8,0 Gew.-% Methanol und etwa 92,0-93,5 Gew.-% 1H-Perfluorhexan enthält.

3. Azeotropartiges Gemisch nach Anspruch 1, das etwa 7,0-7,8 Gew.-% Methanol und 92,2-93,0 Gew.-% 1H-Perfluorhexan enthält.

4. Verfahren zur Reinigung von elektronischen Bauteilen, insbesondere gelöteten Leiterplatten oder gedruckten Schaltungen, dadurch gekennzeichnet, daß man die Bauteile mit einem azeotropartigen Gemisch nach einem der Ansprüche 1 bis 3 wäscht.

5. Verfahren zur Entfernung von Lötflußmitteln, gekennzeichnet durch eine Wäsche mit einem azeotropartigen Gemisch nach einem der Ansprüche 1 bis 3.

## Patentansprüche (Patentansprüche für folgende(n) Vertragsstaat(en): ES)

1. Verfahren zur Reinigung von elektronischen Bauteilen, insbesondere gelöteten Leiterplatten oder gedruckten Schaltungen, dadurch gekennzeichnet, daß man die Bauteile mit einem azeotropartigen Gemisch wäscht, das etwa 5-9 Gew.-% Methanol und etwa 91-95 Gew.-% 1 H-Perfluorhexan enthält.

2. Verfahren nach Anspruch 1, dadurch gekennzeichnet, daß das azeotropartige Gemisch etwa 6,5-8,0 Gew.-% Methanol und etwa 92,0-93,5 Gew.-% 1 H-Perfluorhexan enthält.

3. Verfahren nach Anspruch 1, dadurch gekennzeichnet, daß das azeotropartige Gemisch etwa 7,0-7,8 Gew.-% Methanol und etwa 92,2-93,0 Gew.-% 1 H-Perfluorhexan enthält.

4. Verfahren zur Entfernung von Lötflußmitteln, gekennzeichnet durch eine Wäsche mit einem azeotropartigen Gemisch, das etwa 5-9 Gew.-% Methanol und etwa 91-95 Gew.-% 1 H-Perfluorhexan enthält.

5. Verfahren nach Anspruch 4, dadurch gekennzeichnet, daß das azeotropartige Gemisch etwa 6,5-8,0 Gew.-% Methanol und etwa 92,0-93,5 Gew.-% 1 H-Perfluorhexan enthält.

6. Verfahren nach Anspruch 4, dadurch gekennzeichnet, daß das azeotropartige Gemisch etwa 7,0-7,8 Gew.-% Methanol und etwa 92,2-93,0 Gew.-% 1 H-Perfluorhexan enthält.

## Claims (Claims for the following Contracting State(s): BE, DE, DK, FR, GB, IT, NL)

1. An azeotrope-like mixture which contains about 5-9 % by weight of methanol and about 91-95 % by weight of 1H-perfluorohexane.

2. The azeotrope-like mixture as claimed in claim 1, which contains about 6.5-8.0 % by weight of methanol and about 92.0-93.5 % by weight of 1H-perfluorohexane.

3. The azeotrope-like mixture as claimed in claim 1, which contains about 7.0-7.8 % by weight of methanol and 92.2-93.0 % by weight of 1H-perfluorohexane.

4. A process for cleaning electronic components, in particular soldered circuit boards or printed circuits, characterized in that the components are washed with an azeotrope-like mixture as claimed in one of claims 1 to 3.

5. A process for removing soldering fluxes, characterized by a wash with an azeotrope-like mixture as claimed in one of claims 1 to 3.

## Claims (Claims for the following Contracting State(s): ES)

1. A process for cleaning electronic components, in particular soldered circuit boards or printed circuits, characterized in that the components are washed with an azeotrope-like mixture which contains about 5-9 % by weight of methanol and about 91-95 % by weight of 1H-perfluorohexane.

2. The process as claimed in claim 1, characterized in that the azeotrope-like mixture contains about 6,5-8,0 % by weight of methanol and about 92,0-93,5 % by weight of 1H-perfluorohexane.

3. The process as claimed in claim 1, characterized in that the azeotrope-like mixture contains about 7,0-7,8 % by weight of methanol and about 92,2-93,0 % by weight of 1H-perfluorohexane.

4. A process for removing soldering fluxes, characterized by a wash with an azeotrope-like mixture which contains about 5-9 % by weight of methanol and about 91-95 % by weight of 1H-perfluorohexane.

5. The process as claimed in claim 4, characterized in that the azeotrope-like mixture contains about 6,5-8,0 % by weight of methanol and about 92,0-93,5 % by weight of 1H-perfluorohexane.

6. The process as claimed in claim 4, characterized in that the azeotrope-like mixture contains about 7,0-7,8 % by weight of methanol and about 92,2-93,0 % by weight of 1H-perfluorohexane.

## Revendications (Revendications pour l'(les) Etat(s) contractant(s) suivant(s): BE, DE, DK, FR, GB, IT, NL)

1. Mélange pseudo-azéotropique comprenant environ 5-9 % en poids de méthanol et environ 91-95 % en poids de 1H-perfluorohexane.

2. Mélange pseudo-azéotropique selon la revendication 1, comprenant environ 6,5-8,0 % en poids de méthanol et environ 92,0-93,5 % en poids de 1H-perfluorohexane.

3. Mélange pseudo-azéotropique selon la revendication 1, comprenant environ 7,0-7,8 % en poids de méthanol et environ 92,2-93,0 % en poids de 1H-perfluorohexane.

4. Procédé de nettoyage de composants électroniques, en particulier de cartes de circuits soudés ou de circuits imprimés, caractérisé en ce qu'on lave les composants avec un mélange pseudo-azéotropique conforme à une quelconque des revendications 1 à 3.

5. Procédé pour éliminer des flux de soudure, caractérisé par un lavage avec un mélange pseudo-azéotropique conforme à une quelconque des revendications 1 à 3.

## Revendications (Revendications pour l'(les) Etat(s) contractant(s) suivant(s): ES)

1. Procédé de nettoyage de composants électroniques, en particulier de cartes de circuits soudés ou de circuits imprimés, caractérisé en ce qu'on lave les composants avec un mélange pseudo-azéotropique comprenant environ 5-9 % en poids de méthanol et environ 91-95 % en poids de 1H-perfluorohexane.

2. Procédé selon la revendication 1, caractérisé en ce que le mélange pseudo-azéotropique comprend environ 6,5-8,0 % en poids de méthanol et environ 92,0-93,5 % en poids de 1H-perfluorohexane.

3. Procédé selon la revendication 1, caractérisé en ce que le mélange pseudo-azéotropique comprend environ 7,0-7,8 % en poids de méthanol et environ 92,2-93,0 % en poids de 1H-perfluorohexane.

4. Procédé pour éliminer des flux de soudure, caractérisé par un lavage avec un mélange pseudo-azéotropique comprenant environ 5-9 % en poids de méthanol et environ 91-95 % en poids de 1H-perfluorohexane.

5. Procédé selon la revendication 4, caractérisé en ce que le mélange pseudo-azéotropique comprend environ 6,5-8,0 % en poids de méthanol et environ 92,0-93,5 % en poids de 1H-perfluorohexane.

6. Procédé selon la revendication 4, caractérisé en ce que le mélange pseudo-azéotropique comprend environ 7,0-7,8 % en poids de méthanol et environ 92,2-93,0 % en poids de 1H-perfluorohexane.
